# EUROPÄISCHE PATENTSCHRIFT

(11) **EP 1 537 428 B1**
(45) Veröffentlichungstag und Bekanntmachung des Hinweises auf die Patenterteilung: **06.05.2009**
(21) Anmeldenummer: 03795027.6
(22) Anmeldetag: 05.09.2003
(51) Int. Cl.: G01R 31/34

(54) **VERFAHREN UND VORRICHTUNG ZUR ERFASSUNG VON BÜRSTENFEUER UND FUNKENEROSION AN ELEKTRISCHEN MASCHINEN**
METHOD AND DEVICE FOR DETECTING SPARKING AND SPARK EROSION IN ELECTRIC MACHINES
PROCEDE ET DISPOSITIF POUR DETECTER DES ETINCELLES AUX BALAIS ET DE L'EROSION PAR ETINCELLES DANS DES MACHINES ELECTRIQUES

(30) Priorität: 10.09.2002 CH 153002
(43) Veröffentlichungstag der Anmeldung: 08.06.2005
(73) Patentinhaber: Alstom Technology Ltd, 5401 Baden (CH)
(72) Erfinder: HOBELSBERGER, Max, CH-5303 Würenlingen (CH); KIRCHHOFF, Ingo, CH-5454 Bellikon (CH)
(86) Internationale Anmeldenummer: PCT/EP2003/050612
(87) Internationale Veröffentlichungsnummer: WO 2004/025811

(56) Entgegenhaltungen:
- EP-A- 0 271 678
- DE-A- 19 742 622
- US-A- 3 831 160
- US-A- 4 577 151
- US-A- 4 814 699

## Beschreibung

### TECHNISCHES GEBIET

Die vorliegende Erfindung betrifft ein Verfahren und eine Vorrichtung zur Erfassung von Funkenaktivität einer elektrischen Maschine, insbesondere von Bürstenfeuer, und z.B. dabei auftretende Funkenerosion an Schleifringen, und/oder von Funkenüberschlägen zwischen Teilen der Wellenlager, wie z.B. um Wellenerosionsfunken.

### STAND DER TECHNIK

Funkenaktivität an elektrischen Maschinen, die z.B. in Form von Bürstenfeuer bei Generatoren mit Schleifringen, über die der Erregungsstrom geführt wird, oder in Form von Funkenüberschlägen zwischen Teilen der Wellenlager auftritt, ist üblicherweise äusserst kritisch, da die Gefahr von Funkenerosion besteht. Derartige Funkenaktivität führt zu einer schnellen Abnützung von Schleifringen und damit zu einem möglichen frühzeitigen Ausfall der Kontakte und damit des Erregerfeldes und so der gesamten elektrischen Maschine. Funkenerosion an den Wellenlagern führt zu einer Schädigung der Lager und den damit verbundenen Problemen der Laufruhe respektive von Abnützung. Entsprechend besteht ein grosses Bedürfnis, Funkenaktivität an elektrischen Maschinen zu überwachen respektive rechtzeitig zu erkennen, um im Falle von schädlicher derartiger Aktivität schnell eingreifen zu können, respektive um gegebenenfalls mit Hilfe von Langzeitüberwachung vor Auftreten von schädlicher Funkenaktivität bereits entsprechende Schritte unternehmen zu können.

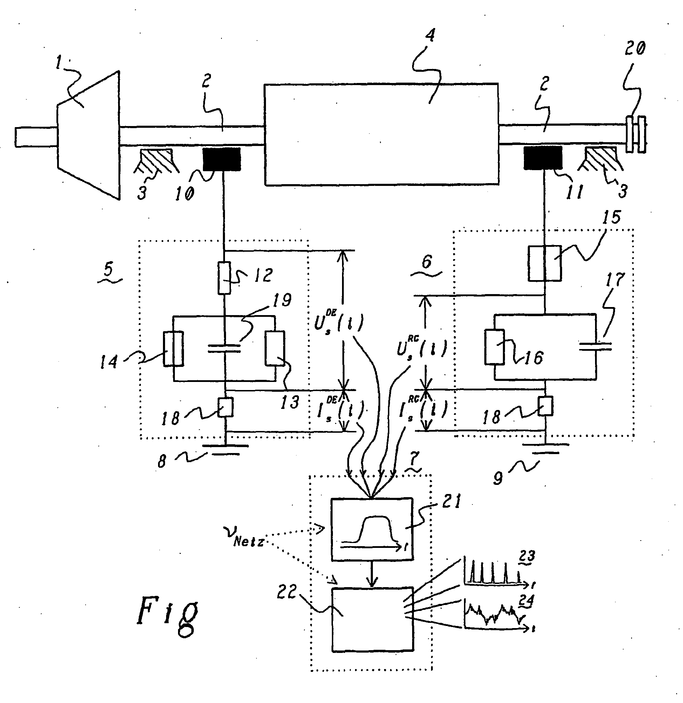

So beschreiben z.B. die US 3,653,019, die US 4,058,804, die US 4,163,227 sowie die US 4,451,786 Verfahren respektive Messgeräte zur Überwachung von Bürstenfeuer. Bei diesen Geräten werden die Signale zur Überwachung direkt an den Bürsten abgegriffen. Das Hauptanliegen dieser Schriften ist es, die von Bürstenfeuer verursachten (Nutz)-Signaie von (Stör)-Signalen zu unterscheiden. Zur Beobachtung der Signale müssen diesen Schriften entsprechend spezifische Abgreifstellen an den Bürsten vorgesehen werden. In diesem Zusammenhang sei z.B. besonders auf die US 4,058,804 hingewiesen, in welcher in Fig. 2A typische, in diesem Zusammenhang relevante Signale und deren Zusammensetzung aus Nutzsignal und Störsignal im Detail angegeben sind. Die Störsignale sind dabei Störsignale, welche von der statischen Erregungseinrichtung stammen, und welche in einem ähnlichen Frequenzbereich auftreten, wie die Nutzsignale. Zur Unterdrückung der Störsignale wird dabei im wesentlichen eine so genannte "Gating"-Methode verwendet, d.h. eine Methode, bei welcher die spezifisch erkennbaren und periodisch auftretenden Ausschläge des Störsignals (Spikes) genutzt werden, um das Störsignal von der Detektion fernzuhalten (blanking) respektive um das eigentliche Beobachtungsfenster erst nach einer bestimmten Zeit nach dem Auftreten des Störsignals (zur Verhinderung eines Erfassens des mit den Störsignalen verbundenen Nachschwingens, auch mit "ringing" bezeichnet) zu öffnen.

Weiterhin sei die US 4,577,151 genannt, in welcher Bürstenfeuer über die Anordnung einer spezifisch dazu vorzusehenden Antenne erfasst werden. Die Antenne wird dabei in der Nähe der Schleifringe angeordnet. Die von der Antenne empfangenen hochfrequenten Signale werden einem Hochfrequenzverstärker zugeführt, demoduliert und anschliessend einem Detektor zugeführt, wo sie auf für Bürstenfeuer charakteristische Komponenten analysiert werden. In dieser Schrift wird auch auf ein älteres System verwiesen, bei dem eine Kamera verwendet wird, um die Lichtblitze von Funken aufzunehmen.

Die Vorrichtungen zur Detektion von Funkenaktivität gem. Stand der Technik weisen den Nachteil auf, dass infolge der Auskoppelung direkt an den Bürsten spezielle Koppeleinrichtungen (z.B. hochzuverlässige Kondensatoren) eingebaut werden müssen, zusammen mit entsprechenden Ableitungen. Auch die Verwendung einer Antenne erfordert die zur Verfügungsstellung eines speziellen Bauteils, welches ausserdem in geeigneter Weise eingebaut werden muss. Problematisch im Zusammenhang mit dem für die Unterdrückung der Störsignale verwendeten "Gating" ist die Tatsache, dass im Zeitbereich der Störaustastung nicht gemessen werden kann. Dieser Bereich kann einen erheblichen Teil der verfügbaren Gesamtzeit ausmachen.

### DARSTELLUNG DER ERFINDUNG

Der Erfindung liegt demnach die Aufgabe zugrunde, ein Verfahren respektive eine Vorrichtung zur Erfassung der Funkenaktivität einer elektrischen Maschine zur Verfügung zu stellen, welche über eine hohe Empfindlichkeit verfügt und dabei konstruktiv einfach und billig zu realisieren ist.

Die Lösung dieser Aufgabe wird dadurch erreicht, dass zur Erfassung der Funkenaktivität die Wellenspannung und/oder der Wellenstrom gemessen und analysiert wird, wie es auf andere weise in US3831160 vorgeschlagen wird.

Wie zum Beispiel in der Druckschrift EP-A1-0 271 678 und der späteren Druckschrift DE-A1-1997 42 622 beschrieben, können an der Generatorwelle eines Generators, der üblicherweise Teil einer Turbogruppe ist, aus verschiedenen Gründen Wellenspannungen und Wellenströme auftreten, deren Frequenzspektrum vom Gleichstrom bis zu Frequenzen reicht, die mit der Rotationsfrequenz des Generators, aber auch mit den Frequenzen eines statischen Erregungssystems des Generators zusammenhängen.

Die Wellenspannungen respektive Wellenströme können auf Grund magnetischer Asymmetrien der Umgebung der Generatorwelle, auf Grund von elektrostatischen Aufladungen der Generatorwelle, auf Grund von äusseren elektrischen Feldern, die Wellenspannungen kapazitiv in die Generatorwelle einkoppeln, oder auf Grund von magnetischen Remaneszenzen in der rotierenden Welle sowie auf Grund von Restmagnetisierung (herstellungsbedingt) der Welle zu Stande kommen.

Die Wellenspannungen und Wellenströme stellen grundsätzlich eine Gefahr für verschiedene Komponenten des Generators dar und können zu Schäden am Generator führen, wenn sie nicht auf ein tolerierbares Mass reduziert werden. Hierzu wurden in der Vergangenheit an der Generatorwelle spezielle Vorkehrungen getroffen, indem beispielsweise auf der Nichtantriebsseite des Generators Isolierstrecken eingebaut und die Generatorwelle auf der Antriebsseite über Bürsten mit dem Erdpotential verbunden wurde. Um diese Bürsten zu entlasten, wurde auch vorgeschlagen, die Generatorwelle an der Nichtantriebsseite mittels eines Gleitkontaktes über eine Kapazität wechselspannungsmässig an das Erdpotential anzukoppeln.

Die Wellenspannungen und Wellenströme können aber auch zur Überwachung der Funktionssicherheit und Funktionstüchtigkeit der Wellenerdung herangebogen werden. Die eingangs genannte Druckschrift EP-A1-0 271 678 gibt dazu eine Überwachungs- und Auswerteschaltung an, die auf der Nichtantriebsseite des Generators durch Parallelschaltung eines Widerstandes zur Ableitungskapazität einen Gleichstrompfad schafft und maschinentypische Frequenzkomponenten in den durch diesen Pfad fliessenden Strömen auswertet. Die RC-Kombination ergibt eine zuverlässige Verbindung zwischen Welle und Erdpotential, welche sowohl statische Aufladungen als auch niederfrequente und höherfrequente Spannungen auf für die Wellenlager ungefährliche Beträge reduziert und eventuelle Ströme in den Lagern auf ungefährliche Werte begrenzt. Durch das Einfügen des Parallelwiderstandes erhält man dann sogar eine Redundanz zur ohmschen Erdung auf der Antriebsseite.

Ein anderer Vorschlag (DE-A1-197 42 622) geht dahin, auf der Antriebsseite den durch eine Erdungsstrecke der Generatorwelle fliessenden Wellenstrom zu messen und eine Frequenz des Wellenstromes zu bestimmen, aus der dann die Ursache des Wellenstromes abgeleitet wird.

Der Kern der Erfindung besteht nun aber in der Erkenntnis, dass der Wellenstrom respektive die Wellenspannung nicht nur die obengenannte Information gemäss der EP-A1-0 271 678 über die Funktionstüchtigkeit und die Funktionssicherheit der Wellenerdung oder auch die Information gemäss der ausserdem zu nennenden EP-A2-0 391 181 über Rotorwindungsschlüsse enthält, sondern dass in diesen Signalen ausserdem eine Information über die Funkenaktivität der elektrischen Maschine enthalten ist. Entsprechend ist es möglich, auf die üblicherweise für die Messung derartiger Funkenaktivität speziell vorzusehende Vorrichtungen zu verzichten, und Wellenspannung respektive Wellenstrom mit den gegebenenfalls bereits vorhandenen Geräten zur Erdung, zur Überwachung der Funktionstüchtigkeit oder der Rotorwindungsschlüsse zu messen und aus den dabei erhaltenen Daten Rückschlüsse über Funkenaktivitäten der Maschine zu machen. Die Messung von Wellenstrom und/oder Wellenspannung ist dabei eine empfindliche und für Langzeitbeobachtungen sehr geeignete Methode zur Ermittlung von derartigen Funkenaktivitäten.

Grundsätzlich ergibt sich daraus der Vorteil, dass die Messung aller Funkenaktivitäten an der Welle (Wellenfunken) möglich wird, z.B. Entladungen über der Lagerschale, und somit nicht nur ein spezifischer Typ von Funkenaktivität gemessen werden kann.

Gemäss einer ersten bevorzugten Ausführungsform des erfindungsgemässen Verfahrens handelt es sich bei der Funkenaktivität um Bürstenfeuer, d.h. um Funken an den Schleifringen, und/oder um Funkenüberschläge zwischen Teilen der Wellenlager, insbesondere um Wellenerosionsfunken. Dabei kann nicht nur die Anwesenheit eines spezifischen Typs von Funkenaktivitäten festgestellt werden, sondern auch deren zeitliche Abfolge und Stärke. Insbesondere bevorzugt wird dabei zur Analyse von Wellenspannung und/oder Wellenstrom das Signal als Funktion der Zeit gemessen und aufgezeichnet, und als Funktion der Zeit analysiert.

Gemäss einer weiteren bevorzugten Ausführungsform erfolgt die Messung von Wellenspannung und/oder Wellenstrom derart, dass an einer ersten Stelle der Welle eine niederohmige Erdung vorgesehen ist, und dass an einer zweiten Stelle der Welle ein hochohmiges RC-Modul vorgesehen ist, über welchem RC-Modul Wellenspannung und/oder Wellenstrom abgegriffen und in einer Analyseeinheit analysiert werden.

Um ausserdem eine Lokalisierung der Aktivität entlang der Welle zu ermöglichen, ist es weiterhin bevorzugt möglich, dass zusätzlich zur Messung der Wellenspannung und/oder des Wellenstroms über das RC-Modul die Wellenspannung und/oder der Wellenstrom über der niederohmigen Erdung abgegriffen und in der Analyseeinheit analysiert werden.

Da es sich bei den durch Funkenaktivität bedingten Signalen mehrheitlich um Signale im Frequenzbereich oberhalb von wenigstens 500 kHz, üblicherweise sogar oberhalb von 700 kHz oder sogar oberhalb von 1 MHz handelt, können nicht mit Funkenaktivität zusammenhängende weitere Signale dadurch eliminiert werden, dass das oder gegebenenfalls die mehreren, der Analyseeinheit zugeführten Signale vor der Analyse durch einen Signalfilter (Hochpass-Filter) geleitet werden. Es handelt es sich bei diesem Filter bevorzugtermassen um einen einstellbaren, steilflankigen Bandpass-Filter, der insbesondere bevorzugt einen Durchlassbereich von ca. 500 kHz Breite aufweist und dessen Mittenfrequenz auf etwas 500kHz bis 50 MHz abgestimmt werden kann.

Dabei wird bevorzugt das resultierende Signal (Spannung oder Strom) in Bezug auf darin enthaltene Frequenzmodulationen und/oder Amplitudenmodulationen untersucht. Bevorzugtermassen wird das Signal dabei nach Demodulation respektive Heruntermischen des Signals mit einer Trägerfrequenz, in Relation zur Netzperiode oder drehsynchron mit der Welle betrachtet (phasenaufgelöste Messung). Auf diese Weise können drehsynchrone Rattermarken der Erregerbürstenbrücke oder Streifstellen detektiert werden.

Gemäss einer weiteren bevorzugten Ausführungsform wird die Messung von Wellenspannung respektive Wellenstrom mit einer Messung von Teilentladungen an den Phasenklemmen koordiniert. Dies erlaubt eine ganzheitliche Analyse der Situation in Bezug auf Funkenaktivität, wobei insbesondere die Lokalisierung der Funkenaktivität vereinfacht wird. Der kausale Zusammenhang zwischen der Aktivität an den Phasenklemmen und der Funkenaktivität kann so einfach hergestellt werden, und es ist möglich, Impulse von Teilentladungen in der Statorwicklung von Funkenaktivitäten an der Welle zu unterscheiden, oder die Teilentladungsmessung zu ergänzen.

Gemäss einer anderen bevorzugten Ausführungsform wird das Signal nach Passieren eines Hochpass-Filters, wie er oben genannt ist, abgetastet und digitalisiert. Anschliessend wird entweder das Zeitsignal, gegebenenfalls nach angepasstem Gating zur Unterdrückung von Störsignalen, auf für Funkenaktivität charakteristische Spitzen analysiert, oder vom Signal werden jeweils Abschnitte fouriertransformiert und entsprechende charakteristische Merkmale im Frequenzspektrum analysiert. Üblicherweise handelt es sich bei den Störsignalen um Thyristorpulse infolge der Gleichrichtung der Erregungsspannung des Generators, welche ebenfalls im hochfrequenten Bereich auftreten können, und welche insbesondere ausserdem zu einem ebenfalls störenden Nachschwingen (ringing) führen können.

Weitere bevorzugte Ausführungsformen des erfindungsgemässen Verfahrens sind in den abhängigen Ansprüchen beschrieben.

Die vorliegende Erfindung betrifft ausserdem eine Vorrichtung zur Durchführung eines Verfahrens, wie es oben beschrieben wurde. Die Vorrichtung zeichnet sich insbesondere dadurch aus, dass die Wellenspannung über einen Schleifkontakt, vorzugsweise über die vorhandene(n) Erdungseinrichtung(en) abgegriffen wird. Der Hochfrequenz-Anteil des Signals wird mittels Koppelimpedanzen ausgekoppelt und weiterverarbeitet.

In einer weiteren Ausführungsform ist an einer ersten Stelle der Welle eine nieder ohmige Erdung der Welle, und an einer zweiten Stelle der Welle ein hochohmiges RC-Modul vorgesehen. Über das RC-Modul werden Wellenspannung und/oder Wellenstrom abgegriffen und in einer Analyseeinheit auf Komponenten analysiert, welche für Funkenaktivität der Welle charakteristisch sind. Um eine genauere Lokalisierung der Funkenaktivität zu ermöglichen, ist es weiterhin vorteilhaft, wenn die niederohmige Erdung über einen niederohmigen Widerstand zur Kontaktvorrichtung an die Welle und über einem hochohmigen Widerstand zur Erde verfügt, wobei parallel zum hochohmigen Widerstand eine Sicherung angeordnet ist. Zusätzlich zur Messung der Wellenspannung und/oder des Wellenstroms über dem RC-Modul werden die Wellenspannung und/oder der Wellenstrom über der niederohmigen Erdung abgegriffen und in der Analyseeinheit analysiert.

Da es sich bei Signalen aufgrund der Funkenaktivität üblicherweise um hochfrequente Signale handelt, kann ausserdem bevorzugtermassen die Analyseeinheit über einen Hochpass-Filter verfügen, durch welchen das oder gegebenenfalls die mehreren, der Analyseeinheit zugeführten Signale vor der Analyse hindurchgeschickt werden. Die Charakteristik des Hochpass-Filters sollte dabei einstellbar und steilflankig sein, wobei insbesondere bevorzugt ein Durchlassbereich mit einer einstellbaren unteren Grenze von 20 kHz bis 1 MHz respektive bis 5 MHz, sowie eine obere Grenze im Bereich von 40 MHz vorliegen sollte (z.B. Bandpass mit ca. 300 kHz Bandbreite, durchstimmbar).

An der Stelle der eigentlichen Messung am RC-Modul erweist es sich als vorteilhaft, wenn das RC-Modul über eine Sicherung zur Kontaktvorrichtung an die Welle und zur Erde über eine oder mehrere parallel angeordnete Kapazitäten sowie parallel dazu über einen Widerstand verfügt, wobei gegebenenfalls zwischen Erde und Kapazität respektive Widerstand ein Messwiderstand (shunt-resistance) angeordnet ist, und wobei die Wellenspannung über der einen oder mehreren Kapazität und der Wellenstrom über dem Messwiderstand abgegriffen werden.

Dabei wird bevorzugtermassen die gemessene Wellenspannung respektive der gemessene Wellenstrom als Funktion der Zeit detektiert und einer Analysevorrichtung zugeführt, wobei die Analysevorrichtung Mittel zur Digitalisierung des Signals (Spannung, Strom), Mittel zur Fouriertransformation dieses digitalisierten Signals, sowie Mittel zur spektralen Darstellung der transformierten Daten aufweist, wobei insbesondere bevorzugt zusätzlich numerisch nach bestimmten Kriterien die Anwesenheit, Art und Intensität von Funkenaktivität automatisch bestimmt und vereinfacht dargestellt wird. Bei den Kriterien handelt es sich dabei um charakteristische Signale im Zeitbereich oder um charakteristische spektrale Eigenschaften der einzelnen Aktivitäten.

Weitere bevorzugte Ausführungsformen der efindungsgemässen Vorrichtung sind in den abhängigen Ansprüchen beschrieben.

### KURZE ERLÄUTERUNG DER FIGUREN

Die Erfindung soll nachfolgend anhand von Ausführungsbeispielen im Zusammenhang mit der Zeichnung näher erläutert werden. Die einzige Figur zeigt eine schematische Darstellung einer Vorrichtung zur Messung von Wellenspannung Uₛ(t) respektive Wellenstrom Iₛ(t) als Funktion der Zeit (t).

### WEGE ZUR AUSFÜHRUNG DER ERFINDUNG

Die Figur zeigt eine schematische Darstellung einer Gasturbinenanlage, bei welcher zwei Turbinen 1 auf den beiden Seiten eines Generators 4 angeordnet sind, wobei die beiden Turbinen 1 wie auch der Generator 4 auf einer einzigen gemeinsamen Welle 2 angeordnet sind. Die zwei Turbinen sind dabei nur beispielhaft zu verstehen, es ist auch möglich, dass nur eine Turbine angeordnet ist. Um den Generator 4 z.B. beim Hochfahren von den Turbinen 1 trennen zu können, sind üblicherweise Kupplungen vorgesehen, welche eine mechanische Entkopplung der Turbinen 1 vom Generator 4 erlauben.

Die Welle 2 ist auf wenigstens zwei Wellenlagern 3 gelagert. Die in den Lagern 3 vorliegenden Ölfilme isolieren die Welle 2 von den mit der Erde in Verbindung stehenden Lagern 3. Diese Isolation bricht aber häufig bei Spannungsspitzen auf der Welle 2 zusammen, was zu Problemen mit Elektroerosion führen kann. Ebenfalls an der Welle 2 befinden sich die Schleifringe 20, über welche die Speisung für die Erregerspulen eingekoppelt wird.

Wie bereits eingangs erwähnt, treten an einer derartigen Welle eines Generators 4 aus verschiedenen Gründen Wellenspannungen und Wellenströme auf, deren Frequenzspektrum vom Gleichstrom bis zu Frequenzen reicht, die mit der Rotationsfrequenz des Generators, aber auch mit den Frequenzen eines statischen Erregungssystems des Generators zusammenhängen.

Die Wellenspannungen respektive Wellenströme kommen unter anderem aufgrund magnetischer Asymmetrien der Umgebung der Welle 2, aufgrund von elektrostatischen Aufladungen der Welle 2, auf Grund von äusseren elektrischen Feldern, die Wellenspannungen kapazitiv in die Welle 2 einkoppeln, oder aufgrund von magnetischen Remanenzen in der rotierenden Welle 2, sowie aufgrund von Restmagnetisierung (herstellungsbedingt) der Welle 2 zu Stande.

Die Wellenspannungen, üblicherweise und im folgenden als Uₛ bezeichnet, und Wellenströme, üblicherweise und im folgenden als. Iₛ bezeichnet, stellen grundsätzlich eine Gefahr für verschiedene Komponenten des Generators dar und können zu Schäden am Generator führen, wenn sie nicht auf ein tolerierbares Mass reduziert werden. Erfindungsgemäss wird nun aber die Wellenspannung respektive der Wellenstrom zur gezielten Analyse und Erfassung von Funkenaktivitäten der elektrischen Maschine verwendet.

Dazu wird auf der einen Seite des Generators 4 eine niederohmige Erdung 5, z.B. ein so genanntes DE-Modul (Driving End Module) an der Welle 2 angeschlossen, welches im wesentlichen eine gesicherte Erdung der Welle 2 zur Erde 8 gewährleistet. Auf der anderen Seite des Generators 4 wird ein so genanntes RC-Modul 6 (R für Widerstand, C für Kapazität), welches mit einer Analyseeinheit 7 verbunden ist, einerseits mit der Welle 2 verbunden und andererseits auf Erde 9 gelegt.

Das DE-Modul 5 ist über eine Kontaktvorrichtung 10 mit der Welle 2 verbunden. Bei der Kontaktvorrichtung 10 handelt es sich vorzugsweise um ein Cu-Geflecht, welches schleifend mit der Welle 2 in elektrischem Kontakt steht. Das DE-Modul 5 ist niederohmig zur Erde 8 ausgebildet, indem zwischen Kontaktvorrichtung 10 und Erde 8 zunächst ein niederohmiger Widerstand 12 geschaltet ist. Typischer weise weist der Widerstand 12 einen Wert R im Bereich von 1 bis 50 Ohm auf. Damit gewährleistet das DE-Modul 5 zunächst eine niederohmige Erdung der Welle 2. Um nun zu verhindern, dass gegebenenfalls unerwünschte, an der Welle 2 anliegende hohe Ströme direkt niederohmig zur Erde 8 abfliessen können, ist in Serie zum Widerstand 12 eine Sicherung 14 parallel zu einem zweiten, hochohmigen Widerstand 13 angeordnet. So wird sichergestellt, dass für den Fall einer ungewollten Stromspitze an der Welle 2 keine niederohmige Verbindung zur Erde 8 vorliegt, da der Strom dann durch den Widerstand 13 begrenzt ist. Typischerweise handelt es sich bei der Sicherung 14 z.B. um eine Sicherung des Typs 2A/250V träge, welche von aussen leicht ersetzt werden kann, und der Widerstand 13 weist einen Wert R im Bereich von 100 bis 1000 Ohm auf. Bei Auftreten von derartigen Spitzen wird die Sicherung 14 entsprechend trennen, wodurch nun der hochohmige Widerstand 13 den Gesamtwiderstand zwischen Welle 2 und Erde 8 entscheidend bestimmt. Ausserdem ist eine als Kondensator ausgebildet Kapazität 19 parallel zum Widerstand 13 angeordnet.

Auf der anderen Seite des Generators 4 ist das RC-Modul 6 angeordnet. Dieses verfügt ebenfalls zur Welle 2 über eine Kontaktvorrichtung 11, welche wiederum bevorzugt in Form eines Cu-Geflechts, welches in elektrischem Kontakt mit der Welle 2 steht, ausgebildet ist. Das RC-Modul 6 weist zunächst zur Welle eine Sicherung 15 auf, üblicherweise eine Sicherung des Typs 2A träge (auch hier dient die Sicherung zum Schutz vor hohen Strömen), und in Serie dazu einen Widerstand 16, zu welchem parallel eine ebenfalls als Kondensator ausgebildete Kapazität 17 angeordnet ist. Ganz allgemein weist der parallel zur Kapazität 17 angeordnete Widerstand 16 einen Wert R von im Bereich von 100 bis 10000 Ohm auf. Die Kapazität 17 weist einen Wert C typischerweise im Bereich von 1 bis 30 µF auf.

Über der Kapazität 17 respektive über dem Widerstand 16 wird nun die Wellenspannung U^{Rc}ₛ(t) als Funktion der Zeit abgegriffen, und über Koaxialkabel der Analyseeinheit 7 übergeben. Zwischen der Erdung 9 und der parallelen Anordnung von Widerstand 16 und Kapazität 17 befindet sich ausserdem ein Messwiderstand 18 (shunt resistance), bei welchem über den darüber auftretenden Spannungsabfall der Wellenstrom I^{RC}ₛ(t) berechnet und mitgeschrieben werden kann. Auch diese Information wird über ein Koaxialkabel an die Analyseeinheit 7 übergeben.

Auch über dem DE-Modul 5 können Wellenspannung U^{DE}ₛ(t) sowie I^{DE}ₛ(t) abgegriffen werden. Die Wellenspannung wird dabei über dem Widerstand 12 abgegriffen, und für das Abgreifen des Wellenstroms ist ausserdem wiederum vor der Erde 8 ein Messwiderstand 18 vorgesehen, bei welchem über den darüber auftretenden Spannungsabfall der Wellenstrom I^{DE}ₛ(t) berechnet und mitgeschrieben werden kann. Auch diese Information wird über ein Koaxialkabel an die Analyseeinheit 7 übergeben.

Die Messung von Wellenspannungen respektive Wellenstrom an den zwei Modulen 5 und 6 erlaubt durch den Vergleich der Werte die grobe Lokalisierung von Funkenaktivität.

Die gemessene Wellenspannung als Funktion der Zeit, Uₛ(t), respektive der gemessene Wellenstrom als Funktion der Zeit, Iₛ(t) enthält nun Informationen über verschiedene, üblicherweise unerwünschte Funkenaktivitäten der elektrischen Maschine. So misst man an diesen Messgrössen ähnliche Signale, wie sie über eine direkte an Kopplung an die Bürsten oder über die Verwendung einer Antenne, wie dies aus dem Stand der Technik bekannt ist.

Die Auswertung von Wellenstrom respektive Wellenspannung erlaubt die frühzeitige Diagnose sowohl von Bürstenfeuer (und damit verbundener Funkenerosion) an den Schleifringen 20, welches sich in Signalen äussert, wie sie beispielsweise in der US 4,163,227 beschrieben und dargestellt sind. Zusätzlich ist aber auch weitere Funkenaktivität an der Welle 2 diagnostizierbar, so z.B. Funkenerosion an den Lagern 3. In beiden Fällen handelt es sich um charakteristische Ausschläge (Spikes) in der Wellenspannung respektive im Wellenstrom. Da es sich bei diesen für Funkenaktivität typischen Signalen um hochfrequente Signale, d.h. um Signale im Frequenzbereich von typischerweise oberhalb 500 kHz handelt, erweist es sich als vorteilhaft, Wellenspannungen respektive Wellenstrom vor der eigentlichen Analyse in der Auswertungseinheit 22 durch einen als Bandpass ausgebildeten Signalfilter 21 zu führen. Die Kommutierungssignale (Thyristorpulsen), welche als Störsignale das Nutzsignal überdecken könnten, sind üblicherweise eher niederfrequent. Ausserdem können so weitere Störsignale unterdrückt werden. Durch die Filterung wird insbesondere auch ermöglicht, im Zeitraum der Thyristorpulse Funkenaktivitäten zu beobachten.

Bei diesem Bandpass-Filter 21 handelt es sich um einen bandselektiven Empfänger, Demodulator und Verstärker, welcher steilflankig und einstellbar ist. Einstellbar heisst, dass er einen Frequenzbereich von 20 kHz bis 40 MHz überstreichen kann, wobei die Mittenfrequenz verschiebbar ist, mit einer Bandbreite von z.B. 300kHz. Als untere Grenze im hier genannten Zusammenhang erweisen sich mindestens 20 kHz als möglich, wobei Störsignale auf den hier relevanten Nutzsignalen typischerweise erst oberhalb von 500 kHz wesentlich ausgeschlossen werden können.

Das durch den Bandpass-Filter 21 geschickte Signal wird anschliessend in der Einheit 22 üblicherweise mit wenigstens 200 kHz Abtastfrequenz abgetastet und digitalisiert. Das Signal kann dann auf die charakteristischen Spikes direkt im Zeitbereich, wie dies in der Figur mit dem Bezugszeichen 24 angegeben ist, untersucht werden. Ausserdem ist es möglich, das Signal in Relation zur Netzfrequenz µ_{Netz}, darzustellen um Periodizitäten im Zusammenhang mit der Rotation der Welle zu erkennen (Phasenauflösung).

Als geeignet für die Analyse erweist sich ausserdem die Analyse mit Hilfe einer Fouriertransformation des Zeitsignals Uₛ(t) oder Iₛ(t). Zur Erhöhung der Messgenauigkeit respektive zur Vereinfachung der Filterung der Eingangsdaten kann das entsprechende Zeitsignal auch hier mit einem Trägersignal (Carrier) gemischt werden und fouriertransformiert (FFT) werden. Als Trägersignal eignet sich auch hier z.B. die Netzfrequenz, welche dazu gegebenenfalls direkt vom Netz oder an einem geeigneten anderen Ort abgegriffen werden muss. Die im Frequenzbereich dargestellten Daten sind in der Figur mit dem Bezugszeichen 23 angegeben.

Das Eingangssignal Us(t) (typischerweise im Bereich von weniger als 3V) respektive Is(t) wird zunächst in einem Analog-Digital-Wandler (ADC) mit einer Abtastfrequenz (Samplingrate) von typischerweise 200 kHz digitalisiert und anschliessend dieses digitalisierte Zeitsignal Uₛ(t) respektive. Iₛ(t) abschnittsweise fouriertransformiert.

Zu beachten ist in diesem Zusammenhang ausserdem, dass sich die vorliegende Methode ganz besonders zur Langzeitbeobachtung des Verhaltens von elektrischen Anlagen eignet So kann aus der graduellen langsamen Veränderung des Verhaltens der Funkenaktivitäten auf gegebenenfalls vorhandenen Revisionsbedarf geschlossen werden, und es können gezielt entsprechende Revisionen geplant und durchgeführt werden.

### BEZUGSZEICHENLISTE

- 1: Turbine
- 2: Welle
- 3: Wellenlager
- 4: Generator
- 5: niederohmige Erdung (Driving End Module, DE-Modul)
- 6: RC-Modul (hochohmig)
- 7: Analyseeinheit
- 8: Erdung von 5
- 9: Erdung von 6
- 10: Kontaktvorrichtung von 5
- 11: Kontaktvorrichtung von 6
- 12: niederohmiger Widerstand
- 13: hochohmiger Widerstand
- 14: Sicherung
- 15: Sicherung
- 16: Widerstand
- 17: Kapazität
- 18: Messwiderstand (Shunt resistance)
- 19: Kapazität
- 20: Schleifringe
- 21: Signalfilter, Bandpass-Filter
- 22: Auswertungseinheit
- 23: Frequenzspektrum
- 24: Signal als Funktion der Zeit
- U^{RC}ₛ(t): Wellenspannung an der RC-Einheit
- I^{RC}ₛ(t): Wellenstrom an der RC-Einheit
- U^{DE}ₛ(t): Wellenspannung an der DE-Einheit
- I^{DE}ₛ(t): Wellenstrom an der DE-Einheit
- µ_{Netz}: Netzfrequenz

## Patentansprüche

1. Verfahren zur Erfassung von Funkenaktivität einer elektrischen Maschine, **dadurch gekennzeichnet, dass** zur Erfassung von Bürstenfeuer und/oder Funkenüberschläger zwischen Teilen der Wellenlager die Wellenspannung (Uₛ(t)) und/oder der Wellenstrom (Iₛ(t)) gemessen und analysiert wird indem an einer ersten Stelle der Welle (2) eine niederohmige Erdungseinrichtung (5) vorgesehen ist, in welcher niederohmigen Erdungseinrichtung (5) die Wellenspannung (U^{DE}ₛ(t)) und/oder der Wellenstrom (I^{DE}ₛ(t)) jeweils über einem Widerstand (12,13,18) abgegriffen und in einer Analyseeinheit (7) analysiert werden, und an einer zweiten Stelle der Welle (2) eine hochohmige Erdungseinrichtung in Form eines RC-Moduls (6) vorgesehen ist, in welchem RC-Modul (6) Wellenspannung (U^{RC}ₛ(t)) und/oder Wellenstrom (I^{RC}ₛ(t)) jeweils über einem Widerstand (16,18) abgegriffen und in der Analyseeinheit (7) analysiert werden, wobei die der Analyseeinheit (7) zugeführten Signale von Wellenspannung und/oder Wellenstrom (I^{DE}ₛ(t)) (U^{DE}s(t),I^{DE}ₛ(t),U^{RC}ₛ(t),I^{RC}ₛ(t)) vor der Analyse durch einen einstellbaren, steilflankigen Bandpass-Filter (21) geführt werden, welcher Bandpass-Filter (21) einen Durchlassbereich im Bereich von 500kHz aufweist und dessen Mittenfrequenz auf im Bereich von 500 kHz bis 50 MHz abgestimmt werden kann.

2. Verfahren nach Anspruch 1, **dadurch gekennzeichnet, dass** es sich beim Bürstenfeuer um dabei auftretende Funken an Schleifringen handelt.

3. Verfahren nach Anspruch 1, **dadurch gekennzeichnet, dass** es sich bei den Funkenüberschlägen zwischen Teilen der Wellenlager um Wellenerosionsfunken handelt.

4. Verfahren nach einem der vorhergehenden Ansprüche, **dadurch gekennzeichnet, dass** zur Analyse Wellenspannung (Uₛ(t)) und/oder Wellenstrom (Iₛ(t)) als Funktion der Zeit (t) gemessen werden.

5. Verfahren nach einem der vorhergehenden Ansprüche, **dadurch gekennzeichnet, dass** Wellenspannung (Uₛ(t)) und/oder Wellenstrom (Iₛ(t)) über wenigstens eine Kontaktvorrichtung (10,11) in Form eines Schleifkontakts von der Welle (2) abgegriffen werden.

6. Verfahren nach einem der vorhergehenden Ansprüche, **dadurch gekennzeichnet, dass** dem Bandpass-Filter (21) ein Amplitudendemodulator nachgeschaltet ist.

7. Verfahren nach einem der vorhergehenden Ansprüche, **dadurch gekennzeichnet, dass** zur Analyse der Signale von Wellenspannung (Uₛ(t)) und/oder Wellenstrom (Iₛ(t)) das entsprechende Signal (Uₛ(t), Iₛ(t)) in Bezug auf darin enthaltene Frequenzmodulationen und/oder Amplitudenmodulationen untersucht wird.

8. Verfahren nach Anspruch 7, **dadurch gekennzeichnet, dass** das Signal (Uₛ(t), Iₛ(t)) phasensynchron zur Netzspannung demoduliert wird.

9. Verfahren nach einem der vorhergehenden Ansprüche, **dadurch gekennzeichnet, dass** die Messung von Wellenspannung (Uₛ(t)) respektive Wellenstrom (Iₛ(t)) mit einer Messung von Teilentladungen an den Phasenklemmen koordiniert wird.

10. Verfahren nach einem der vorhergehenden Ansprüche, **dadurch gekennzeichnet, dass** das Signal (Uₛ(t),Iₛ(t)) nach Passieren des Bandpass-Filters (21) abgetastet und digitalisiert wird, und anschliessend entweder das Zeitsignal, gegebenenfalls nach angepasstem Gating zur Unterdrückung von Störsignalen, auf für Bürstenfeuer und/oder Funkenüberschläge zwischen Teilen der Wellenlager charakteristische Spitzen analysiert wird, oder vom Signal jeweils Abschnitte fouriertransformiert werden und entsprechende charakteristische Merkmale im Frequenzspektrum analysiert werden.

11. Verfahren nach Anspruch 10, **dadurch gekennzeichnet, dass** es sich bei den Störsignalen insbesondere um Thyristorpulse infolge der Gleichrichtung der Erregung des Generators (4) handelt.

12. Vorrichtung zur Durchführung eines Verfahrens nach einem der Ansprüchen 1 bis 11 , **dadurch gekennzeichnet, dass**
an einer ersten Stelle der Welle (2) eine niederohmige Erdungseinrichtung (5) vorgesehen ist, in welcher niederohmigen Erdungseinrichtung (5) die Wellenspannung (U^{DE}ₛ(t)) und/oder der Wellenstrom (I^{DE}ₛ(t)) jeweils über einem Widerstand (12,13,18) abgegriffen und in einer Analyseeinheit (7) auf Komponenten analysiert werden, welche für Bürstenfeuer und/oder Funkenüberschläge zwischen Teilen der Wellenlager charakteristisch sind, dass
an einer zweiten Stelle der Welle (2) eine hochohmige Erdungseinrichtung in Form eines RC-Moduls (6) vorgesehen ist, in welchem RC-Modul (6) Wellenspannung (U^{Rc}ₛ(t)) und/oder Wellenstrom (I^{RC}ₛ(t)) jeweils über einem Widerstand (16,18) abgegriffen und in der Analyseeinheit (7) auf Komponenten analysiert werden, welche für Bürstenfeuer und/oder Funkenüberschläge zwischen Teilen der Wellenlager charakteristisch sind,
und dass die Analyseeinheit (7) über einen einstellbaren, steilflankigen Bandpass-Filter (21) verfügt mit einem Durchlassbereich im Bereich von 500kHz dessen Mittenfrequenz auf im Bereich von 500 kHz bis 50 MHz abgestimmt werden kann, durch welchen Bandpass-Filter (21) die der Analyseeinheit (7) zugeführten Signale von Wellenspannung und/oder Wellenstrom (U^{DE}ₛ(t),I^{DE}ₛ(t),U^{RC}ₛ(t),I^{RC}ₛ(t)) vor der Analyse hindurchgeführt werden.

13. Vorrichtung gemäss Anspruch 12, **dadurch gekennzeichnet, dass** die niederohmige Erdungseinrichtung (5) über einen niederohmigen Widerstand (12) zu einer Kontaktvorrichtung (10) an die Welle (2) und über einen hochohmigen Widerstand (13) zur Erdung (8) verfügt, wobei parallel zum hochohmigen Widerstand (13) und mit diesem eine Parallelschaltung bildend eine Sicherung (14) angeordnet ist.

14. Vorrichtung gemäss einem der Ansprüche 12 bis 13, **dadurch gekennzeichnet, dass** das RC-Modul (6) über eine Sicherung (15) zu einer Kontaktvorrichtung (11) an die Welle (2) und über eine oder mehrere parallel angeordnete Kapazitäten (17) sowie parallel dazu über einen Widerstand (16) zur Erdung (9) verfügt, wobei gegebenenfalls zwischen Erdung (9) und der Parallelschaltung von Kapazität(en) (17) und Widerstand (16) ein Messwiderstand (18) angeordnet ist, und wobei die Wellenspannung (Uₛ(t)) über der einen Kapazität (17) oder der Mehrzahl von Kapazitäten (17), und/oder der Wellenstrom (Iₛ(t)) über dem Messwiderstand (18) abgegriffen wird.

15. Vorrichtung gemäss einem der Ansprüche 12 bis 14, **dadurch gekennzeichnet, dass** die gemessene Wellenspannung (Uₛ(t)) respektive der gemessene Wellenstrom (Iₛ(t)) als Funktion der Zeit detektiert und der Analyseeinheit (7) zugeführt wird, wobei die Analyseeinheit (7) Mittel zur Digitalisierung des Signals (Uₛ(t), Iₛ(t)), Mittel zur Fouriertransformation dieses digitalisierten Signals, sowie Mittel zur spektralen Darstellung der transformierten Daten aufweist, wobei insbesondere bevorzugt zusätzlich numerisch nach bestimmten Kriterien die Anwesenheit, Art und Intensität von Funkenaktivität automatisch bestimmt und vereinfacht dargestellt werden.

## Claims

1. Method for detection of spark activity in an electrical machine, **characterized in that,** in order to detect brush sparking and/or spark flashovers between parts of the shaft bearings, the shaft voltage (Uₛ(t)) and/or the shaft current (Iₛ(t)) are/is measured and analyzed **in that** a low-value earthing device (5) is provided at a first point on the shaft (2), in which low-value earthing device (5) the shaft voltage (U^{DE}ₛ(t)) and/or the shaft current (I^{DE}ₛ(t)) are/is in each case tapped off via a resistor (12, 13, 18) and are/is analyzed in an analysis unit (7), and, at a second point on the shaft (2), a high-value earthing device is provided in the form of an RC module (6) in which RC module (6) the shaft voltage (U^{RC}ₛ(t)) and/or the shaft current (I^{RC}ₛ(t)) respectively are/is in each case tapped off via a resistor (16, 18) and are/is analyzed in the analysis unit (7), with the signals which are supplied to the analysis unit (7) of the shaft voltage and/or shaft current (I^{DE}ₛ(t)) (U^{DE}ₛ(t), I^{DE}ₛ(t), U^{RC}ₛ(t), I^{RC}ₛ(t) are passed through an adjustable, steep-flank bandpass filter (21) before analysis, which bandpass filter (21) has a passband in the region of 500 kHz, and whose mid-frequency can be tuned in the range from 500 kHz to 50 MHz.

2. Method according to Claim 1, **characterized in that** brush sparking in this case comprises sparks which occur on slip rings.

3. Method according to Claim 1, **characterized in that** spark flashovers between parts of the shaft bearings are shaft erosion sparks.

4. Method according to one of the preceding claims, **characterized in that** the shaft voltage (Uₛ(t)) and/or the shaft current (Iₛ(t)) are/is measured as a function of the time (t) for analysis.

5. Method according to one of the preceding claims, **characterized in that** the shaft voltage (Uₛ(t)) and/or the shaft current (Iₛ(t)) are/is tapped off from the shaft (2) via at least one contact apparatus (10, 11) in the form of a sliding contact.

6. Method according to one of the preceding claims, **characterized in that** the bandpass filter (21) is followed by an amplitude demodulator.

7. Method according to one of the preceding claims, **characterized in that** the corresponding signal (Uₛ(t), Iₛ(t)) is investigated with respect to frequency modulations and/or amplitude modulations contained therein, for analysis of the signals of shaft voltage (Uₛ(t)) and/or shaft current (Iₛ(t)).

8. Method according to Claim 7, **characterized in that** the signal (Uₛ(t),Iₛ(t)) is demodulated in synchronism with the phase of the power supply system voltage.

9. Method according to one of the preceding claims, **characterized in that** the measurement of the shaft voltage (Uₛ(t)) and/or the shaft current (Iₛ(t)) is coordinated with a measurement of partial discharges at the phase terminals.

10. Method according to one of the preceding claims, **characterized in that** the signal (Uₛ(t), Iₛ(t)) is sampled and digitized after passing through the bandpass filter (21), and then either the time signal, possibly after matched gating in order to suppress interference signals, is analyzed for characteristic spikes which are characteristic of brush sparking and/or spark flashovers between parts of the shaft bearings, or sections of the signal are in each case Fourier-transformed, and corresponding characteristic features in the frequency spectrum are analyzed.

11. Method according to Claim 10, **characterized in that** the interference signals are, in particular, thyristor pulses resulting from the rectification of the excitation of the generator (4).

12. Apparatus for carrying out a method according to one of Claims 1 to 11, **characterized in that** a low-value earthing device (5) is provided at a first point on the shaft (2), in which low-value earthing device (5) the shaft voltage (U^{DE}ₛ(t)) and/or the shaft current (I^{DE}ₛ(t)) are/is in each case tapped off via a resistor (12, 13, 18) and are/is analyzed in an analysis unit (7) for components which are characteristic of brush sparking and/or spark flashovers between parts of the shaft bearings, **in that**
a high-value earthing device is provided in the form of an RC module (6) at a second point on the shaft (2), in which RC module (6) the shaft voltage (U^{RC}ₛ(t)) and/or the shaft current (I^{RC}ₛ(t)) respectively are/is in each case tapped off via a resistor (16, 18) and are/is analyzed in the analysis unit (7), for components which are characteristic of brush sparking and/or spark flashovers between parts of the shaft bearings,
and **in that** the analysis unit (7) has an adjustable, steep-flank bandpass filter (21) with a passband in the region of 500 kHz whose mid-frequency can be tuned in the range from 500 kHz to 50 MHz, through which bandpass filter (21) the signals which are supplied to the analysis unit (7), of the shaft voltage and/or shaft current (U^{DE}ₛ(t), I^{DE}ₛ(t), U^{RC}ₛ(t), I^{RC}ₛ(t) are passed before analysis.

13. Apparatus according to Claim 12, **characterized in that** the low-value earthing device (5) has a low-value resistor (12) to a contact apparatus (10) the shaft (2) and has a high-value resistor (13) to earth (8), with a fuse (14) being arranged in parallel with the high-value resistor (13), and forming a parallel circuit with it.

14. Apparatus according to one of Claims 12 or 13, **characterized in that** the RC module (6) has a fuse (15) to a contact apparatus (11) on the shaft (2) and has one or more capacitances (17), which are arranged in parallel, as well as a resistor (16) in parallel therewith to earth (9), with a measurement resistor (18) possibly being arranged between earth (9) and the parallel circuit formed by the capacitance or capacitances (17) and the resistor (16), and with the shaft voltage (Uₛ(t)) being tapped off via one of the capacitances (17) or via the plurality of capacitances (17), and/or with the shaft current (Iₛ(t)) being tapped off via the measurement resistor (18).

15. Apparatus according to one of Claims 12 to 14, **characterized in that** the measured shaft voltage (Uₛ(t)) and/or the measured shaft current (Iₛ(t)) are/is detected as a function of time, and are/is supplied to the analysis unit (7), with the analysis unit (7) having means for digitizing the signal (Uₛ(t), Iₛ(t)), means for Fouriertransformation of this digitized signal, and means for spectral display of the transformed data, in particular with the presence, nature and intensity of the spark activity being determined automatically and displayed in a simplified form, preferably additionally numerically on the basis of specific criteria.

## Revendications

1. Procédé de détection de l'activité radio d'une machine électrique,
**caractérisé en ce que**
pour détecter des étincelles de balai et/ou des claquages dûs aux étincelles entre des parties des paliers d'arbres, la tension d'arbre (Uₛ(t)) et/ou le courant d'arbre (Iₛ(t)) sont mesurés et analysés en prévoyant en un premier emplacement de l'arbre (2) un dispositif (5) de raccordement à la terre à basse résistance,
**en ce que** la tension d'arbre (U^{DE}ₛ(t)) et/ou le courant d'arbre (I^{DE}ₛ(t)) sont saisis par l'intermédiaire d'une résistance respective (12, 13, 18) dans le dispositif (5) de raccordement à la terre à basse résistance sont analysés dans une unité d'analyse (7),
**en ce qu'**un dispositif de raccordement à la terre à haute résistance qui présente la forme d'un module RC (6) est prévu en un deuxième emplacement de l'arbre (2),
**en ce que** la tension d'arbre (U^{RC}ₛ(t) et/ou le courant d'arbre (I^{RC}ₛ(t)) sont saisis par l'intermédiaire d'une résistance respective (16, 18) dans le module RC (6) et sont analysés dans l'unité d'analyse (7),
**en ce que** les signaux de tension d'arbre et/ou de courant d'arbre (I^{DE}ₛ(t)), (U^{DE}ₛ(t), I^{DE}ₛ(t), U^{RC}ₛ(t), I^{RC}ₛ(t)) apportés à l'unité d'analyse (7) sont passés avant l'analyse à travers un filtre passe-bande (21) réglable et à flancs accusés et
**en ce que** le filtre passe-bande (21) présente une plage passante de l'ordre de 500 kHz dont la fréquence centrale peut être réglée dans la plage de 500 kHz à 50 MHz.

2. Procédé selon la revendication 1, **caractérisé en ce que** les étincelles de balai sont les étincelles qui surviennent sur les bagues coulissantes.

3. Procédé selon la revendication 1, **caractérisé en ce que** les claquages dûs aux étincelles entre des parties des paliers d'arbre sont des étincelles dues à l'érosion de l'arbre.

4. Procédé selon l'une des revendications précédentes, **caractérisé en ce que** pour l'analyse, la tension d'arbre (Uₛ(t)) et/ou le courant d'arbre (Iₛ(t)) sont mesurés en fonction du temps (t).

5. Procédé selon l'une des revendications précédentes, **caractérisé en ce que** la tension d'arbre (Uₛ(t)) et/ou le courant d'arbre (Iₛ(t)) sont saisis sur l'arbre (2) par l'intermédiaire d'au moins un dispositif (10, 11) de mise en contact qui présente la forme d'un contact coulissant.

6. Procédé selon l'une des revendications précédentes, **caractérisé en ce qu'**un modulateur d'amplitude est raccordé en aval du filtre passe-bande (21).

7. Procédé selon l'une des revendications précédentes, **caractérisé en ce que** pour l'analyse des signaux de tension d'arbre (Uₛ(t)) et/ou de courant d'arbre (Iₛ(t)), la présence de modulations de fréquence et/ou de modulations d'amplitude est vérifiée sur le signal respectif (Uₛ(t)), (Iₛ(t)).

8. Procédé selon la revendication 7, **caractérisé en ce que** le signal (Uₛ(t)), (Iₛ(t)) est démodulé en synchronisme de phase par rapport à la tension du réseau.

9. Procédé selon l'une des revendications précédentes, **caractérisé en ce que** la mesure de la tension d'arbre (Uₛ(t)) ou du courant d'arbre (Iₛ(t)) est coordonnée avec une mesure des décharges partielles sur les bornes de phase.

10. Procédé selon l'une des revendications précédentes, **caractérisé en ce qu'**après avoir traversé le filtre passe-bande (21), le signal (Uₛ(t),Iₛ(t)) est échantillonné et numérisé et **en ce qu'**ensuite, le signal temporel, éventuellement après filtrage adapté pour diminuer les signaux parasites, est analysé pour y déceler les étincelles aux balais et/ou les claquages par étincelles entre des parties des paliers d'arbre, ou **en ce que** des parties du signal subissent une transformation de Fourier et les caractéristiques correspondantes du spectre de fréquence sont analysées.

11. Procédé selon la revendication 10, **caractérisé en ce que** les signaux parasites sont en particulier des impulsions de thyristor provoquées par le redressement de l'excitation du générateur (4).

12. Dispositif en vue de l'exécution d'un procédé selon l'une des revendications 1 à 11, **caractérisé en ce que**
en un premier emplacement de l'arbre (2) est prévu un dispositif (5) de raccordement à la terre à basse résistance, la tension d'arbre (U^{DE}ₛ(t)) et/ou le courant d'arbre (I^{DE}ₛ(t)) étant saisis par l'intermédiaire d'une résistance respective (12, 13, 18) dans le dispositif (5) de raccordement à la terre à basse résistance et leurs composantes caractéristiques d'étincelles aux balais et/ou de claquage par étincelles entre des parties des paliers d'arbre étant analysées dans une unité d'analyse (7),
**en ce qu'**en un deuxième emplacement de l'arbre (2) est prévu un dispositif de raccordement à la terre à haute résistance qui présente la forme d'un module RC (6), la tension d'arbre (U^{RC}ₛ(t)) et/ou le courant d'arbre (I^{RC}ₛ(t) étant saisis par l'intermédiaire d'une résistance respective (16, 18) dans le module RC (6) et leurs composantes caractéristiques d'étincelles aux balais et/ou de claquages dûs aux étincelles entre des parties des paliers d'arbre étant analysées dans l'unité d'analyse (7) et
**en ce que** l'unité d'analyse (7) dispose d'un filtre passe-bande (21) réglable et à flancs accusés, dont la plage passante de l'ordre de 500 kHz peut avoir sa fréquence centrale réglée dans une plage de 500 kHz à 50 MHz, les signaux de tension d'arbre et/ou de courant d'arbre (U^{DE}ₛ(t), I^{DE}ₛ(t), U^{RC}ₛ(t), I^{RC}ₛ(t) apportés à l'unité d'analyse (7) étant passés à travers le filtre passe-bande (21) avant l'analyse.

13. Dispositif selon la revendication 12, **caractérisé en ce que** le dispositif (5) de raccordement à la terre à basse résistance dispose d'une résistance (12) de basse valeur ohmique par rapport à un dispositif (10) de mise en contact prévu sur l'arbre (2) et d'une résistance (13) à haute valeur ohmique destinée au raccordement à la terre (8), une protection (14) étant disposée en parallèle avec la résistance (13) à haute valeur ohmique et formant avec cette dernière un circuit parallèle.

14. Dispositif selon l'une des revendications 12 à 13, **caractérisé en ce que** le module RC (6) dispose d'une protection (15) sur un dispositif (11) de mise en contact prévu sur l'arbre (2) et d'une ou de plusieurs capacités (17) disposées en parallèle et, parallèlement à celles-ci, d'une résistance (16) de raccordement à la terre (9), **en ce qu'**une résistance de mesure (18) est éventuellement disposée entre le raccordement à la terre (9) et le circuit parallèle formé de la ou des capacités (17) et de la résistance (16), **en ce que** la tension d'arbre (Uₛ(t)) est saisie par l'intermédiaire d'une des capacités (17) ou des différentes capacités (17) et/ou **en ce que** le courant d'arbre (Iₛ(t)) est saisi par l'intermédiaire de la résistance de mesure (18).

15. Dispositif selon l'une des revendications 12 à 14, **caractérisé en ce que** la tension d'arbre (Uₛ(t)) mesurée et le courant d'arbre (Iₛ(t)) mesuré sont détectés et apportés à l'unité d'analyse (7) en fonction du temps, **en ce que** l'unité d'analyse (7) présente des moyens de numérisation du signal (Uₛ(t), (Iₛ(t)), de moyens de transformation par Fourier de ce signal numérisé ainsi que de moyens de représentation spectrale des données transformées et **en ce que** de façon particulièrement préférable, la présence, la nature et l'intensité de l'activité d'étincelles sont déterminées automatiquement et présentées de manière simplifiée, de préférence de manière numérique et en fonction de critères définis.
